(19) Europäisches Patentamt
European Patent Office
Office européen des brevets

(11) **EP 4 734 300 A1**

(12) **EUROPEAN PATENT APPLICATION**

(43) Date of publication:
**29.04.2026 Bulletin 2026/18**

(21) Application number: **25210659.6**

(22) Date of filing: **23.10.2025**

(51) International Patent Classification (IPC):
*H01S 5/00* (2006.01)　　*H01S 5/12* (2021.01)
*H01S 5/22* (2006.01)　　*H01S 5/028* (2006.01)
*H01S 5/042* (2006.01)　　*H01S 5/10* (2021.01)
*H01S 5/20* (2006.01)　　*H01S 5/343* (2006.01)
*H01S 5/125* (2006.01)

(52) Cooperative Patent Classification (CPC):
**H01S 5/0014; H01S 5/04253; H01S 5/1003;
H01S 5/1231; H01S 5/125; H01S 5/2009;
H01S 5/22;** H01S 5/0287; H01S 5/04252;
H01S 5/1039; H01S 5/34333; H01S 2301/176

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **25.10.2024 JP 2024188479
16.09.2025 JP 2025153038**

(71) Applicant: **NICHIA CORPORATION
Tokushima 774-8601 (JP)**

(72) Inventors:
• **HIROSE, Ryohei
Tokushima, 774-8601 (JP)**
• **OGAWA, Hisashi
Tokushima, 774-8601 (JP)**

(74) Representative: **Betten & Resch
Patent- und Rechtsanwälte PartGmbB
Maximiliansplatz 14
80333 München (DE)**

(54) **SEMICONDUCTOR LASER ELEMENT**

(57) A semiconductor laser element includes: a semiconductor layered portion including first and second semiconductor layer portions respectively including first and second conductivity-type semiconductor layers, and an active layer between them; a ridge in the semiconductor layered portion; and a diffraction grating. One end surface of the semiconductor laser element serves as a light-emitting surface. The ridge includes, a first ridge, and a second ridge including a first protective film on the semiconductor layered portion and located at a light-emitting surface side in a top view. The diffraction grating is located between the second semiconductor layer portion and the first protective film and has a periodic structure alternately including parts of the second semiconductor layer portion and the first protective film. In a top view, an outer periphery of the first protective film excluding the light-emitting surface side and a boundary between the first and second ridges is located between outer peripheries of the second ridge and the diffraction grating.

Fig. 1

**Description**

BACKGROUND

Technical Field

The present disclosure relates to a semiconductor laser element.

Background Art

In recent years, semiconductor laser elements have been used for a wide variety of purposes. As a semiconductor laser element, for example, a laser element having good spectral characteristics, such as a laser element including a diffraction grating, is widely used. In the laser element including the diffraction grating, the diffraction grating may be disposed on a surface of a semiconductor layered portion (for example, see Japanese Patent Publication No. 2006-165027).

SUMMARY

An object of the present disclosure is to provide a semiconductor laser element in which degradation is reduced.

A semiconductor laser element according to an embodiment of the present disclosure includes: a semiconductor layered portion including a first semiconductor layer portion including a first conductivity-type semiconductor layer, a second semiconductor layer portion including a second conductivity-type semiconductor layer, and an active layer disposed between the first semiconductor layer portion and the second semiconductor layer portion; a ridge provided in the semiconductor layered portion; and a diffraction grating. One end surface of the semiconductor laser element serves as a light-emitting surface. The ridge includes, in a top view, a first ridge extending in a first direction, and a second ridge including a first protective film provided on the semiconductor layered portion, the second ridge located at a side of the light-emitting surface. The diffraction grating has a periodic structure alternately including a part of the second semiconductor layer portion and a part of the first protective film, and is located between the second semiconductor layer portion and the first protective film in the second ridge. The first protective film is provided such that, in a top view, an outer periphery of the first protective film excluding the side of the light-emitting surface and a boundary between the first ridge and the second ridge is located between an outer periphery of the second ridge and an outer periphery of the diffraction grating.

A semiconductor laser element according to the embodiment of the present disclosure can provide a semiconductor laser element with suppressed degradation.

BRIEF DESCRIPTION OF DRAWINGS

FIG. 1 is a schematic top view of a semiconductor laser element according to a first embodiment of the present disclosure.
FIG. 2 is a schematic cross-sectional view taken along line II-II of the semiconductor laser element illustrated in FIG. 1.
FIG. 3 is a schematic cross-sectional view taken along line III-III of the semiconductor laser element illustrated in FIG. 1.
FIG. 4 is a schematic cross-sectional view taken along line IV-IV of the semiconductor laser element illustrated in FIG. 1.
FIG. 5 is a schematic top view illustrating an overview of a waveguide structure of the semiconductor laser element illustrated in FIG. 1.
FIG. 6 is a diagram illustrating an overview of a method for measuring a beam waist radius $W_0$ and a beam divergence angle $\varphi$.
FIG. 7 is a flowchart illustrating a method for manufacturing the semiconductor laser element according to the first embodiment of the present disclosure.
FIG. 8 is a schematic cross-sectional view of a semiconductor layered portion prepared in a step of preparing the semiconductor layered portion.
FIG. 9 is a schematic cross-sectional view of a state where a mask is formed in a step of forming recessed portions of a diffraction grating.
FIG. 10 is a schematic top view of FIG. 9.
FIG. 11 is a schematic cross-sectional view of a state where the recessed portions of the diffraction grating are formed in a step of forming the recessed portions.
FIG. 12 is a schematic top view of FIG. 11.
FIG. 13 is a schematic cross-sectional view of a state where a positive electrode is formed in a step of forming the positive electrode.
FIG. 14 is a schematic top view of FIG. 13.
FIG. 15 is a schematic cross-sectional view of a state where a mask is formed in a step of forming a first protective film of the diffraction grating.
FIG. 16 is a schematic top view of FIG. 15.
FIG. 17 is a schematic cross-sectional view of a state where the first protective film of the diffraction grating is formed in the step of forming the first protective film.
FIG. 18 is a schematic top view of FIG. 17.

DETAILED DESCRIPTION

Certain embodiments, modified examples, and examples for implementing the invention according to the present disclosure will be described below with reference to the accompanying drawings. A semiconductor laser element according to the present disclosure described below is intended to embody technical ideas of the invention according to the present disclosure, but the invention according to the present disclosure is not limited to the following description unless otherwise specifically stated.

1. First Embodiment

A semiconductor laser element L1 according to a first embodiment of the present disclosure includes a semiconductor layered portion 30 including a first semiconductor layer portion 310 including a first conductivity-type semiconductor layer, a second semiconductor layer portion 330 including a second conductivity-type semiconductor layer, and an active layer 320 disposed between the first semiconductor layer portion 310 and the second semiconductor layer portion 330, and a ridge 135 provided in the semiconductor layered portion 30. One end surface of the semiconductor laser element L1 serves as a light-emitting surface. The ridge 135 includes, in a top view, a first ridge 135a extending in a first direction, and a second ridge 135b including a first protective film 50 disposed on the semiconductor layered portion 30 and located on the light-emitting surface side. A diffraction grating 20 having a periodic structure alternately including a part 330a of the second semiconductor layer portion 330 and a part 50a of the first protective film 50 is provided between the second semiconductor layer portion 330 and the first protective film 50 in the second ridge 135b. The first protective film 50 is provided such that, in a top view, an outer periphery 501 of the first protective film 50 excluding the light-emitting surface side thereof and a boundary between the first ridge 135a and the second ridge 135b is located between an outer periphery 135b1 of the second ridge 135b and an outer periphery 201 of the diffraction grating 20.

As described above, in the semiconductor laser element L1 according to the first embodiment of the present disclosure, the first protective film 50 is provided such that, in a top view, the outer periphery 501 of the first protective film 50 excluding the light-emitting surface side thereof and the boundary between the first ridge 135a and the second ridge 135b, is located between the outer periphery 135b1 of the second ridge 135b and the outer periphery 201 of the diffraction grating 20. This allows the first protective film constituting a part of the diffraction grating to be appropriately disposed at a necessary position.

For example, when the outer periphery 501 of the first protective film 50 is located inward of the outer periphery 201, a cavity containing air is formed in a portion that is to constitute a part of the diffraction grating 20, which might cause degradation of the diffraction grating.

Further, when the first protective film 50 is provided such that the outer periphery 501 of the first protective film 50 coincides with the outer periphery of the diffraction grating 20, the outer periphery 501 of the first protective film 50 might be located inward of the outer periphery 201 due to a manufacturing error.

However, such a problem can be solved in the semiconductor laser element L1 according to the first embodiment of the present disclosure.

In addition, when the outer periphery 501 of the first protective film 50 is located outward of the outer periphery 135b1 of the second ridge 135b, a lateral surface of the second ridge 135b (a portion where the semiconductor is exposed) might be covered with the first protective film 50 made of, for example, an oxide. This may cause oxidization of the lateral surface of the second ridge 135b, in which an electric field strength increases when laser light is guided, particularly in the vicinity of a lower end of the lateral surface, thereby causing a decrease in reliability. In particular, when the first protective film 50 is provided by an atomic layer deposition method (ALD method), the oxidative effect may be strong.

However, in the semiconductor laser element L1 according to one embodiment of the present disclosure, such a problem can be solved. That is, the semiconductor laser element L1 according to one embodiment of the present disclosure can provide a semiconductor laser element with reduced degradation.

In the following, a configuration and effects of the semiconductor laser element L1 according to one embodiment of the present disclosure will be described in detail.

In the following description, "height direction" means a layering direction of the semiconductor layered portion 30, and is indicated by a Z-axis in the drawings. The length in the height direction may be simply referred to as "height" or "thickness." "Periodic direction" means a direction of the periods of the diffraction grating 20, and is indicated by an X-axis in the drawings. "Width direction" means a direction perpendicular to both the height direction and the periodic direction, and is indicated by a Y axis in the drawings. The length in the width direction may be simply referred to as "width."

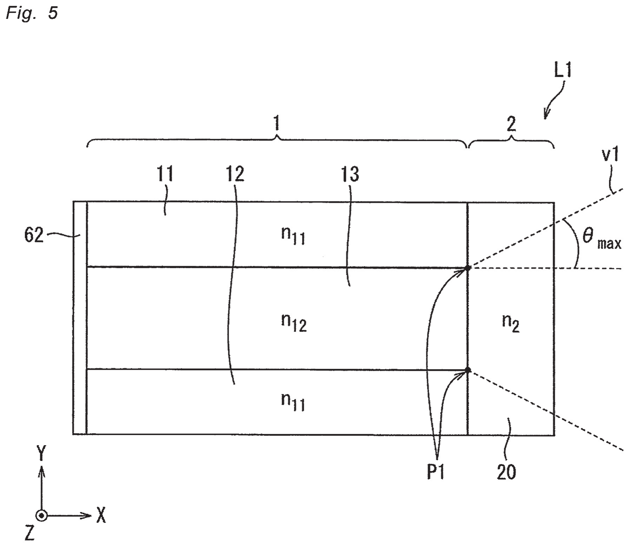

First, an overview of laser oscillation and waveguide of the semiconductor laser element L1 will be described with reference to FIG. 5. The semiconductor laser element L1 includes a first waveguide portion 1 in which laser oscillation occur and a second waveguide portion 2 that includes the diffraction grating 20. The first waveguide portion 1 includes a first core portion 13 having an effective refractive index of $n_{12}$, and a first cladding portion 11 and a second cladding portion 12, each located on a respective one of two sides of the first core portion 13 and each having an effective refractive index of $n_{11}$, and light is confined in a width direction of the first waveguide portion 1. As illustrated in FIG. 5, for example, a high-reflective film 62 is provided on an end surface of the first waveguide portion 1 located on the opposite side of the second waveguide portion 2, and the diffraction grating 20 feeds back, to the first waveguide portion 1, a part of light having a wavelength corresponding to the Bragg wavelength of the light incident from the first waveguide portion 1. The first waveguide portion 1 configured as described above confines the emitted light in the first core portion 13 to resonate the light, thereby causing laser oscillation in one or more transverse modes. This allows the semiconductor laser element L1 to have a high output. The number of the transverse modes of the laser light oscillated in the first waveguide portion 1 is set based on a width of the first core portion 13 between the first cladding portion 11 and the second cladding portion 12. The second waveguide portion 2 is not intended to confine light in the width direction, but has a function of propagating the laser light incident from the first waveguide portion 1, and has an effective refractive index $n_2$. The second waveguide portion 2 is preferably configured to propagate the laser light incident from the first waveguide portion 1 at a maximum diffusion angle $\Theta_{max}$. In other words, it is preferable that both end portions of the second waveguide portion 2 in the width direction are located outward of imaginary lines that diverge at the maximum diffusion angle $\Theta_{max}$ from a boundary between the first waveguide portion 1 and the second waveguide portion 2, which is indicated by point P1 in FIG. 5. This can inhibit leakage of light from both lateral surfaces of the second waveguide portion 2. The maximum diffusion angle $\Theta_{max}$ is an angle at which the laser light incident on the second waveguide portion 2 from the first waveguide portion 1 is caused to diverge and guided by the second waveguide portion 2, and the angle is determined by an effective refractive index of the first core portion 13 of the first waveguide portion 1, an effective refractive index of the first cladding portion 11 of the first waveguide portion 1, an effective refractive index of the second cladding portion 12 of the first waveguide portion 1, and an effective refractive index of the second waveguide portion 2. The maximum diffusion angle $\Theta_{max}$ is also referred to as a maximum light-receiving angle. As described above, the semiconductor laser element L1 includes the first waveguide portion 1 and the second waveguide portion 2, and the first waveguide portion 1 is a region including an optical waveguide that can guide one or more transverse modes. The second waveguide portion 2 is a region that returns a part of the laser light incident from the first waveguide portion 1 to the first waveguide portion 1 and causes a part of the laser light to emit from the light-emitting surface. The semiconductor laser element L1 of the first embodiment includes the diffraction grating 20, and thus wavelength selectivity of the diffraction grating 20 enables laser oscillation and narrowing of spectral line width of the oscillated laser light.

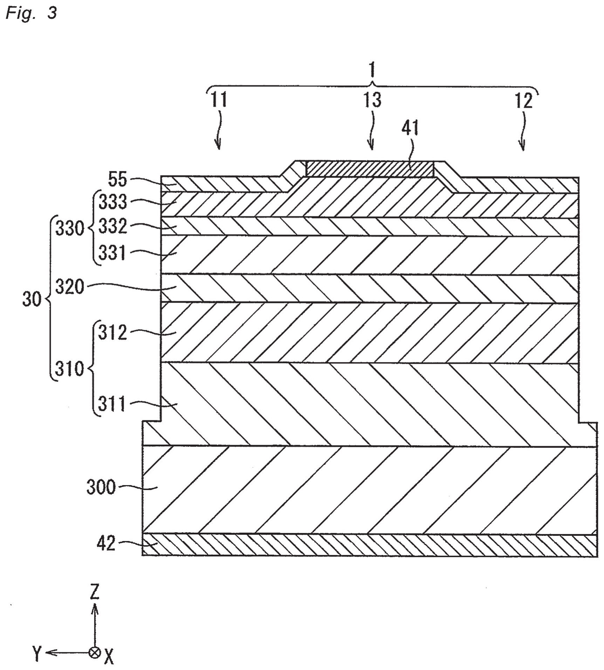

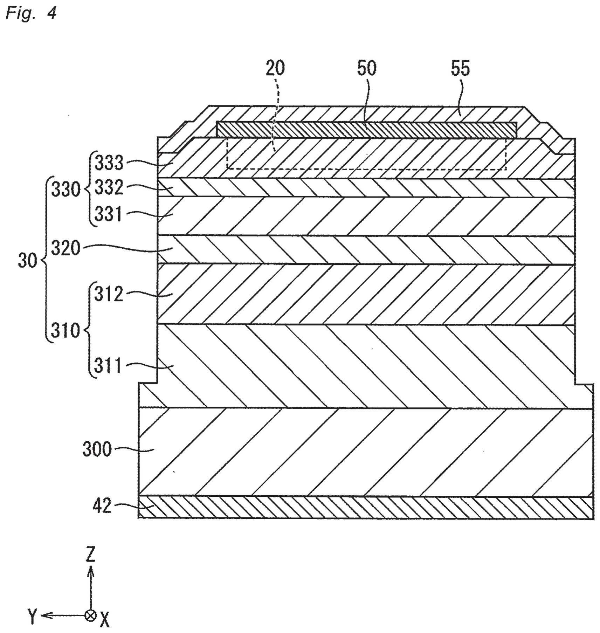

A waveguide structure of the semiconductor laser element L1 described above is formed by the ridge 135 provided in the semiconductor layered portion 30. The ridge 135 includes the first ridge 135a provided in the first waveguide portion 1 and the second ridge 135b provided in the second waveguide portion 2. In the first waveguide portion 1, the first core portion 13 is a region including an active layer located below the first ridge 135a, and the first cladding portion 11 and the second cladding portion 12 are regions including the active layers on both sides below the first ridge 135a. The second waveguide portion 2 includes an active layer below the second ridge 135b, and preferably, both lateral surfaces of the second ridge 135b are provided so as to be located outward of the imaginary lines diverging at the maximum diffusion angle $\Theta_{max}$ illustrated in FIG. 5. As illustrated in FIGS. 3 and 4, the lateral surfaces of the first ridge 135a and the second ridge 135b may be inclined in the height direction, and in this case, the width of the ridge 135 is the width of a lower end of the ridge 135.

In the case in which laser light of the plurality of transverse modes is oscillated in the semiconductor laser element L1, the diffraction grating 20 is preferably provided such that both ends of the diffraction grating 20 are located outward of the beam in consideration of the divergence of the beam of the laser light. This makes it possible to make the wavelength selection by the diffraction grating 20 substantially constant regardless of different transverse modes. Specifically, an oscillation wavelength $\lambda$ of the semiconductor laser element L1 is represented by the following Equation (1) using a period $\Lambda$ of the diffraction grating 20 and the effective refractive index $n_2$ of the second waveguide portion 2. By increasing the width of the diffraction grating, the effective refractive index $n_2$ can be made substantially independent of the transverse mode, and variation in the diffraction wavelength due to the difference in the transverse mode can be inhibited.

$$\lambda = 2 \times \Lambda \times n_2 \ (1)$$

The overview and the effects of the semiconductor laser element L1 have been described above. In the following, each configuration will be described more specifically.

In the following description, "undoped layer" is a semiconductor layer into which no impurity is intentionally introduced, and the undoped layer may contain an inevitable impurity. For example, the undoped layer may unintentionally contain impurities above and/or below the undoped layer, and may contain, for example, an n-type impurity or a p-type impurity at an impurity concentration of $1 \times 10^{-17}$ cm$^{-3}$ or less. For example, the concentration of the impurity contained in the undoped layer is equal to or less than a limit value of detection by secondary ion mass spectrometry (SIMS).

Semiconductor Layered Portion 30

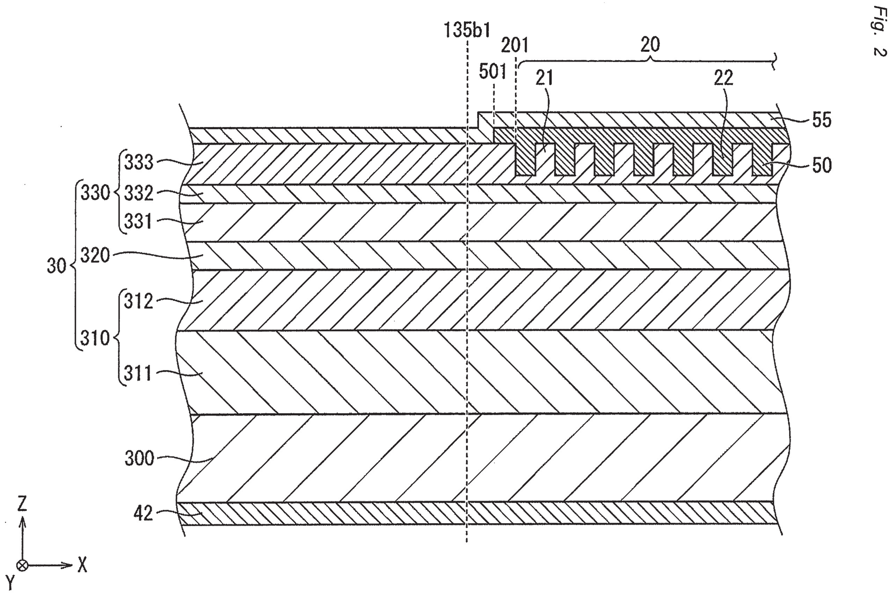

The semiconductor layered portion 30 includes a first conductivity-side semiconductor layer, a second conductivity-side semiconductor layer, and the active layer 320 disposed between the first conductivity-side semiconductor layer and the second conductivity-side semiconductor layer. The first conductivity-side semiconductor layer is a structure including one or more layers including a layer containing an impurity of a first conductivity-type. However, the first conductivity-side semiconductor layer may include an undoped layer. A second conductivity-side semiconductor layer is a structure including one or more layers including a layer containing an impurity of a second conductivity-type. However, the second conductivity-side semiconductor layer may include an undoped layer. The first conductivity-side semiconductor layer is, for example, an n-side semiconductor layer including a layer containing the n-type impurity. The second conductivity-side semiconductor layer is, for example, a p-side semiconductor layer including a layer containing the p-type impurity. In the following description, the first conductivity-side semiconductor layer is an n-side semiconductor layer portion 310, and the second conductivity-side semiconductor layer is a p-side semiconductor layer portion 330. As illustrated in FIGS. 2 to 4, the semiconductor layered portion 30 is disposed on a substrate 300 and includes the n-side semiconductor layer portion 310, the p-side semiconductor layer portion 330, and the active layer 320 disposed between the n-side semiconductor layer portion 310 and the p-side semiconductor layer portion 330. The high-reflective film 62 is provided on the end surface of the semiconductor layered portion 30 on the opposite side of the second waveguide portion 2. An anti-reflective film is preferably provided on the end surface of the semiconductor layered portion 30 on the opposite side of the first waveguide portion 1, that is, the light-emitting surface. A negative electrode 42 is provided on a lower surface of the substrate 300, and a positive electrode 41 is provided on the p-side semiconductor layer portion 330. In the semiconductor laser element L1 of the first embodiment, the positive electrode 41 is provided on the p-side semiconductor layer portion 330 in the first ridge 135a.

n-side Semiconductor Layer Portion 310

The n-side semiconductor layer portion 310 includes one or more n-type semiconductor layers. The n-side semiconductor layer portion 310 may include one or more undoped layers. The n-side semiconductor layer portion 310 includes an n-side cladding layer 311 and an n-side light guide layer 312. The n-side cladding layer 311 is disposed between the substrate 300 and the n-side light guide layer 312. The thickness of the n-side cladding layer 311 is, for example, in a range of 450 nm to 3000 nm. The concentration of the n-type impurity is, for example, in a range of $1 \times 10^{-17}$ cm$^{-3}$ to $5 \times 10^{-18}$ cm$^{-3}$. The thickness of the n-side light guide layer 312 is, for example, in a range of 50 nm to 500 nm. The concentration of the n-type impurity is, for example, in a range of $1 \times 10^{-17}$ cm$^{-3}$ to $5 \times 10^{-18}$ cm$^{-3}$. The band gap energy of the n-side light guide layer 312 is smaller than the band gap energy of the n-side cladding layer 311, that is, the refractive index of the n-side light guide layer 312 is greater than the refractive index of the n-side cladding layer 311.

The n-side semiconductor layer portion 310 is made of, for example, a nitride semiconductor, and may be AlGaN, GaN, InGaN, or the like. The n-side semiconductor layer portion 310 may have a composition between the compositions of these nitride semiconductors. The n-type impurity contained in the n-side semiconductor layer portion 310 is, for example, Si, Ge, or O.

Active Layer 320

The active layer 320 is disposed between the n-side semiconductor layer portion 310 and the p-side semiconductor layer portion 330. The active layer 320 may be a single quantum well layer or a multiple quantum well layer, and includes one or more well layers and two or more barrier layers. The well layer is sandwiched between two barrier layers. The active layer 320 is made of, for example, a nitride semiconductor, and may be AlGaN, GaN, InGaN, or the like. The active layer 320 may have a composition between the compositions of these nitride semiconductors. The active layer 320 emits light by excitation by a current or light. The emission wavelength at this time may be, for example, in a range of 360 nm to 570 nm, and preferably in a range of 380 nm to 450 nm.

p-side Semiconductor Layer Portion 330

The p-side semiconductor layer portion 330 includes one or more p-type semiconductor layers. The p-side semiconductor layer portion 330 may include one or more undoped layers. The p-side semiconductor layer portion 330 includes a first p-side semiconductor layer 331, an electron blocking layer 332, and a second p-side semiconductor layer 333. The electron blocking layer 332 is disposed between the first p-side semiconductor layer 331 and the second p-side semiconductor layer 333. The p-side semiconductor layer portion 330 is made of, for example, a nitride semiconductor, and may be AlGaN, GaN, InGaN, or the like. The p-side semiconductor layer portion 330 may have a composition between the compositions of these nitride semiconductors. The p-type impurity contained in the p-side semiconductor layer portion 330 is, for example, Mg or Be.

First p-side Semiconductor Layer 331

The first p-side semiconductor layer 331 is, for example, an undoped layer. By including the first p-side semiconductor layer 331, which is the undoped layer, a peak position of an electric field intensity distribution of light can be located away from a semiconductor layer containing the p-type impurity, and thus, the loss due to absorption of light can be reduced. The thickness of the first p-side semiconductor layer may be in a range of 200 nm to 1000 nm, and preferably in a range of 300 nm to 600 nm.

Electron Blocking Layer 332

The electron blocking layer 332 is a semiconductor layer having a greater band gap energy than the first p-side semiconductor layer 331 and the second p-side semiconductor layer 333. Because the barrier to electrons is large, the loss of electrons in the active layer 320 can be reduced. The electron blocking layer 332 may include one or more p-type semiconductor layers. The p-type impurity is, for example, Mg. The concentration of the p-type impurity is, for example, in a range of $1 \times 10^{18}$ cm$^{-3}$ to $1 \times 10^{20}$ cm$^{-3}$, and preferably in a range of $5 \times 10^{18}$ cm$^{-3}$ to $5 \times 10^{19}$ cm$^{-3}$. The thickness of the electron blocking layer 332 is, for example, in a range of 5 nm to 30 nm, and preferably in a range of 5 nm to 15 nm.

Second p-side Semiconductor Layer 333

The second p-side semiconductor layer 333 is a layer in contact with the positive electrode 41. The second p-side semiconductor layer 333 functions as, for example, the light guide layer. The second p-side semiconductor layer 333 may include one or more p-type semiconductor layers. The p-type impurity is, for example, Mg. The concentration of the p-type impurity may be, for example, in a range of $1 \times 10^{18}$ cm$^{-3}$ to $1 \times 10^{19}$ cm$^{-3}$. The thickness of the second p-side semiconductor layer 333 may be, for example, in a range of 50 nm to 500 nm. The second p-side semiconductor layer 333 may have a multilayer structure, and the concentration of the p-type impurity of the second p-side semiconductor layer 333 in contact with the positive electrode 41 may be higher than the concentration of the p-type impurity in the other portion. The concentration of the p-type impurity of the second p-side semiconductor layer 333 in contact with the positive electrode 41 is in a range of $1 \times 10^{20}$ cm$^{-3}$ to $1 \times 10^{21}$ cm$^{-3}$, for example. The second p-side semiconductor layer 333 may further include a p-side cladding layer, and the p-side cladding layer may be in contact with the positive electrode 41.

First Waveguide Portion 1

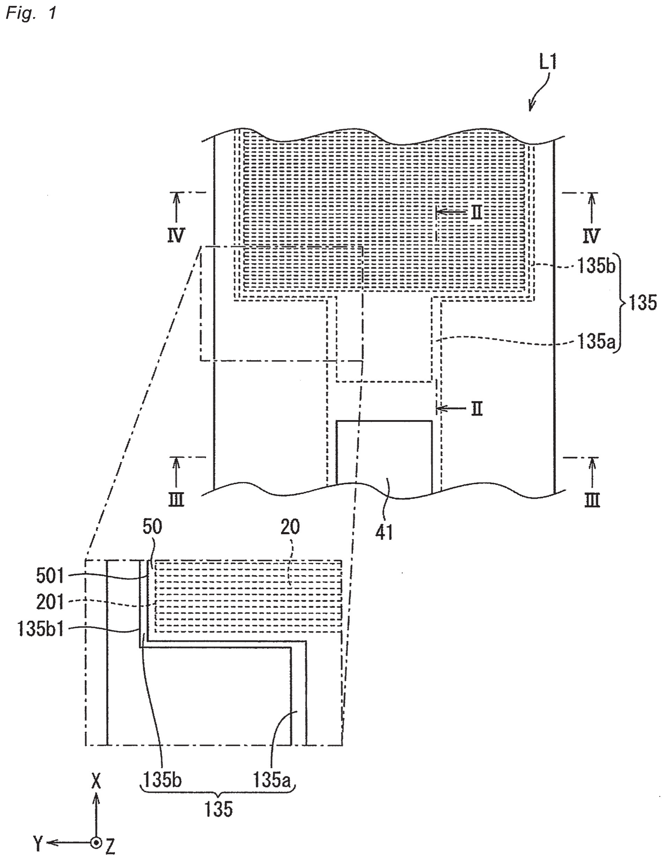

The first waveguide portion 1 will be described with reference to FIG. 3. FIG. 3 is a schematic cross-sectional view taken along line III-III in FIG. 1, and is a schematic cross-sectional view perpendicular to an optical axis of the optical waveguide. The first waveguide portion 1 includes the first cladding portion 11, the second cladding portion 12, and the first core portion 13 located between the first cladding portion 11 and the second cladding portion 12. The first waveguide portion 1 is a waveguide that propagates light in one or more transverse modes. The first waveguide portion 1 includes at least the n-side semiconductor layer portion 310, the active layer 320, and the p-side semiconductor layer portion 330. As illustrated in FIG. 3, the first core portion 13 is a region including the first ridge 135a, and further includes at least the n-side semiconductor layer portion 310, the active layer 320, and the p-side semiconductor layer portion 330, which are located below the first ridge 135a. The first cladding portion 11 and the second cladding portion 12 are regions sandwiching the first core portion 13, and each include at least the n-side semiconductor layer portion 310, the active layer 320, and the p-side semiconductor layer portion 330, which are located at positions excluding the lower side of the first ridge 135a. The effective refractive index of the first cladding portion 11 is $n_{11}$, the effective refractive index of the second cladding portion 12 is $n_{11}$, and the effective refractive index of the first core portion 13 is $n_{12}$. The effective refractive index $n_{12}$ is greater than the effective refractive index $n_{11}$. These effective refractive indices are effective refractive indices in consideration of light confinement in the height direction in the first waveguide portion 1. That is, $n_{11}$ and $n_{12}$ are effective refractive indices focusing on the height directions of the respective regions.

The width of the first core portion 13 is set based on the number of modes of light to be guided. For example, the width is in a range of 1 $\mu$m to 100 $\mu$m. This makes it easy to secure heat dissipation while controlling the number of transverse modes. The width of the first ridge 135a may be regarded as the width of the first core portion 13.

The width of the first cladding portion 11 may be, for example, in a range of 15 $\mu$m to 500 $\mu$m. The width of the second cladding portion 12 may be, for example, in a range of 15 $\mu$m to 500 $\mu$m. The width of the first cladding portion 11 is preferably substantially equal to the width of the second cladding portion 12. This makes it possible to easily adjust a maximum diffusion angle $\Theta_{max}$ described later.

The number of the modes exited in the first waveguide portion 1 may be in a range of 1 to 500, preferably in a range of 10 to 300, more preferably in a range of 30 to 100. This makes it possible to obtain the semiconductor laser element L1 that can narrow the width of a peak of an oscillation wavelength and has a high power.

Second Waveguide Portion 2

The second waveguide portion 2 will be described with reference to FIG. 4. FIG. 4 is a schematic cross-sectional view taken along line IV-IV in FIG. 1. The second waveguide portion 2 includes the first protective film 50, and includes the diffraction grating 20 including a part of the first protective film 50 and a part of the p-side semiconductor layer portion 330 alternately in the p-side semiconductor layer portion 330. The second waveguide portion 2 includes the second ridge 135b, and at least the n-side semiconductor layer portion 310, the active layer 320, and the p-side semiconductor layer portion 330, which are located below the second ridge 135b. The effective refractive index of the second waveguide por-

tion 2 is $n_2$ that is an effective refractive index obtained by averaging the refractive index modulation of the diffraction grating 20 and in consideration of optical confinement in the layering direction of the semiconductor layered portion 30.

That is, $n_2$ is the effective refractive index. The effective refractive index $n_2$ selects the wavelength of the laser light based on the above-described Equation (1).

The width of the second waveguide portion 2 is preferably larger than the width of the core portion of the first waveguide portion 1. Further, the width of the second waveguide portion 2 is preferably larger than the divergence of the light propagating through the second waveguide portion 2. In other words, the width of the second ridge 135b is preferably set to be larger than the width of the beam diameter of the laser light guided through the width region of the second waveguide portion 2 overlapping the second ridge 135b. This reduces the variation in the effective refractive index for each transverse mode, and narrows the spectral line width of the laser light. The beam diameter is defined, for example, by D4σ (second moment width). The way of divergence of the light in the second waveguide portion 2 is based on the maximum diffusion angle $\Theta_{max}$ determined by the effective refractive index $n_{12}$ of the first core portion 13 of the first waveguide portion 1, the effective refractive index $n_{11}$ of the first cladding portion 11 of the first waveguide portion 1, the effective refractive index $n_{11}$ of the second cladding portion 12 of the first waveguide portion 1, and the effective refractive index $n_2$ of the second waveguide portion 2. The width of the second waveguide portion 2 is equal to or larger than the width of the diffraction grating 20. The width of the second ridge 135b is larger than the width of the first ridge 135a. This reduces the variation in the effective refractive index for each transverse mode, and narrows the spectral line width of the laser light.

Diffraction Grating 20

The diffraction grating 20 is formed by a periodic structure of the p-side semiconductor layer portion 330 and the first protective film 50 made of a material different from that of the p-side semiconductor layer portion 330. This increases the flexibility in selecting a refractive index difference between the p-side semiconductor layer portion 330 and the first protective film 50, as compared with the case in which the diffraction grating is formed using semiconductors having different mixed crystal ratios. With this periodic structure, the diffraction grating 20 has a reflectance with respect to a predetermined wavelength. As illustrated in FIG. 2, the diffraction grating 20 is constituted by a plurality of protrusions 21 provided on the p-side semiconductor layer portion 330 and the first protective film 50 disposed between the plurality of protrusions 21. Specifically, the diffraction grating 20 includes the protrusions 21 formed from the p-side semiconductor layer portion 330 and the first protective film 50 disposed in recesses 22 formed in the p-side semiconductor layer portion 330, each of the recesses 22 located between adjacent ones of the protrusions 21.

Although FIG. 2 illustrates the diffraction grating 20 including the plurality of protrusions 21 provided on the second p-side semiconductor layer 333 and the first protective film 50 disposed between the plurality of protrusions 21, the present embodiment is not limited to this, and the diffraction grating 20 may include the plurality of protrusions 21 provided in a plurality of layers of the p-side semiconductor layer portion 330 including a layer below the p-side semiconductor layer portion 330 and the first protective film 50 disposed between the plurality of protrusions 21.

That is, a lower end surface of the recessed portions 22 of the diffraction grating 20, that is, a lower end of the diffraction grating 20 may be located at any position of the second p-side semiconductor layer 333, the electron blocking layer 332, or the first p-side semiconductor layer 331, and is appropriately set in consideration of the following advantages.

For example, the diffraction grating 20 including the plurality of protrusions 21 provided on the second p-side semiconductor layer 333 and the first protective film 50 disposed between the protrusions 21 can have a constant refractive index in the thickness (height) direction of the protrusions 21, and thus a diffraction grating having good wavelength selectivity can be easily formed.

In the diffraction grating 20 including the plurality of protrusions 21 provided in the plurality of layers of the p-side semiconductor layer portion 330 including the layer below the p-side semiconductor layer portion 330 and the first protective film 50 disposed between the plurality of protrusions 21, the effective refractive index of the protrusions 21 needs to be set in consideration of the effective refractive index of the p-side semiconductor layer portion 330 and the thicknesses of the plurality of layers included in the protrusions 21, but there is an advantage described below.

For example, when the lower end of the diffraction grating 20 is located in the first p-side semiconductor layer 331, the diffraction grating 20 is located close to the active layer 320, and thus the wavelength can be efficiently selected.

In consideration of the above, the height of the protrusion 21 of the diffraction grating 20 (the depth of the recessed portion 22 of the diffraction grating 20) is appropriately set, and is, for example, in a range of 50 nm to 500 nm. The height of the protrusion 21 of the diffraction grating 20 (the depth of the recessed portion 22 of the diffraction grating 20) is, for example, in a range of 100 nm to 200 nm, and thereby, the reflectance is increased as compared with the case in which the height of the protrusion 21 of the diffraction grating 20 (the depth of the recessed portion 22 of the diffraction grating 20) is less than 50 nm.

The first protective film 50 is provided such that the outer periphery 501 excluding the light-emitting surface side and the boundary between the first ridge 135a and the second ridge 135b is located between the outer periphery of the second ridge 135b and the outer periphery of the diffraction grating 20 in a top view. That is, the outer periphery 501 of the first protective film 50 is not located inward of the outer periphery 201, and the outer periphery 501 of the first protective film 50 is not located outside the outer periphery 135b1 of the second ridge 135b. When the outer periphery 501 of the first protective film 50 is not located inward of the outer periphery 201, the possibility of forming a cavity in a portion that is to constitute a part of the diffraction grating 20 can be reduced, and degradation of the diffraction grating can be reduced. Further, when the outer periphery 501 of the first protective film 50 is not located outward of the outer periphery 135b1 of the second ridge 135b, the lateral surface of the second ridge 135b (the portion where the semiconductor is exposed) is not covered with the first protective film 50, and the possibility that the lateral surface of the second ridge 135b is oxidized can be reduced.

The first protective film 50 can use various materials used as the protective film, and the diffraction grating 20 having a desired reflectance can be obtained by appropriately selecting the material of the first protective film 50 in consideration of the refractive index thereof. As described above, the material of the first protective film 50 can be selected from various materials. The material of the first protective film 50 is preferably an oxide, a fluoride, or a nitride, and thus the lateral surfaces of the plurality of protrusions 21 (or the lateral surfaces of the plurality of recessed portions 22) can be protected by the first protective film 50, and the degradation of the p-side semiconductor layer can be suppressed. The oxide is, for example, $SiO_2$ or $TiO_2$, and is preferably $SiO_2$. When the first protective film 50 is $SiO_2$, a desired reflectance can be obtained while protecting the lateral surfaces of the protrusions 21 (or the recessed portions 22) from leakage. The fluoride is, for example, $MgF_2$, $BaF_2$, or $LaF_3$. The nitride is, for example, SiN, SiON, or AlN. By selecting the first protective film 50 from $SiO_2$, $Al_2O_3$, SiN, or SiON, it is possible to obtain a desired reflectance as the diffraction grating 20 while protecting the lateral surfaces of the protrusions 21 (or the recessed portions 22) from leakage. The first protective film 50 can be provided by, for example, the atomic layer deposition method (ALD method).

The period A of the diffraction grating 20 is appropriately determined in consideration of the wavelength to be selected. The period A of the diffraction grating 20 is, for example, in a range of 60 nm to 400 nm, preferably from 70 nm to 300 nm, and more preferably from 80 nm to 250 nm. This increases the reflectance of the desired wavelength.

The length of the diffraction grating 20 in the periodic direction (the length including all the periods) is, for example, in a range of 50 $\mu$m to 500 $\mu$m. This makes it possible to obtain a desired reflection band. The length of the diffraction grating 20 in the periodic direction is, for example, preferably in a range of 100 $\mu$m to 500 $\mu$m, or in a range of 100 $\mu$m to 300 $\mu$m. This makes it possible to narrow the reflection band and the spectral line width of the laser light, as compared with the case in which the length of the diffraction grating 20 in the periodic direction is less than 100 $\mu$m.

Further, the longer the length of the diffraction grating 20 in the periodic direction is, the higher the reflectance of the diffraction grating 20 can be made. As described above, the diffraction grating 20 can adjust the reflectance and the reflection band by various parameters. In other words, in the diffraction grating 20, the various parameters described above are set so that the desired reflectance and the desired reflection band can be obtained. For example, when the length of the diffraction grating 20 in the periodic direction is in a range of 50 $\mu$m to 500 $\mu$m, the height of the diffraction grating 20 is set to be, for example, in a range of 50 nm to 500 nm. For example, when the length of the diffraction grating 20 in the periodic direction is in a range of 100 $\mu$m to 300 $\mu$m, the height of the diffraction grating 20 is set to be, for example, in a range of 100 nm to 200 nm. By setting the height within this range, the desired reflection band can be obtained while increasing the reflectance at a predetermined wavelength.

The width of the diffraction grating 20 is preferably larger than the width of the first core portion 13 of the first waveguide portion 1, and for example, the width of the diffraction grating 20 is set to be twice or more the width of the first core portion 13. By increasing the width of the diffraction grating 20 in this manner, for example, even when laser oscillation is performed in the plurality of transverse modes, the variation in the effective refractive index for each transverse mode is reduced, and the spectral line width of the laser light can be narrowed. The width of the diffraction grating 20 is, for example, in a range of 30 $\mu$m to 9000 $\mu$m, in a range of 45 $\mu$m to 900 $\mu$m, in a range of 45 $\mu$m to 500 $\mu$m, or in a range of 60 to 300 $\mu$m.

In consideration of the divergence of the laser light in the second waveguide portion 2, it is preferable to provide the diffraction grating 20 with a wider width than the maximum diffusion angle $\Theta_{max}$ regardless of whether the laser oscillation is single-mode laser oscillation or multi-mode laser oscillation. This allows the entire laser light to be efficiently reflected.

A second protective film 55 covering the first protective film 50 is preferably provided on the first protective film 50 on the diffraction grating 20. In a case in which the first protective film 50 is provided so as to cover the entire diffraction grating 20 as illustrated in FIG. 2, the second protective film 55 is provided so as to cover the entire first protective film 50. In a case in which the first protective film 50 is embedded in the recessed portions 22 except for the upper end surfaces of the protrusions 21 of the p-side semiconductor layer portion 330, the second protective film 55 is provided so as to be in contact with the upper end surfaces of the protrusions 21. The second protective film 55 is, for example, an oxide provided by sputtering. By providing the second protective film 55, it is possible to increase resistance of the diffraction grating 20 to oxidation. When the second protective film 55 is directly provided on the protrusions 21 of the p-side semiconductor layer portion 330, the second protective film 55 does not enter between the plurality of protrusions 21 of the p-side semiconductor layer portion 330. This forms a cavity containing air in a portion that is to constitute a part of the diffraction grating 20, which might cause degradation of the p-side semiconductor layer portion 330. Thus, it is preferable to form the diffraction grating 20 by completely covering the p-side semiconductor layer portion 330 with the first protective film 50, and to cover the first protective film 50 with the second protective film 55. In a case in which the first protective film 50 is provided by the atomic layer deposition method (ALD method) and the second protective film 55 is provided by the sputtering, the oxidative effect of the second protective film 55 is smaller than that of the first protective film 50. Thus, even when the ridge 135 is covered with the second protective film 55, the ridge 135 is less likely to be oxidized to degrade.

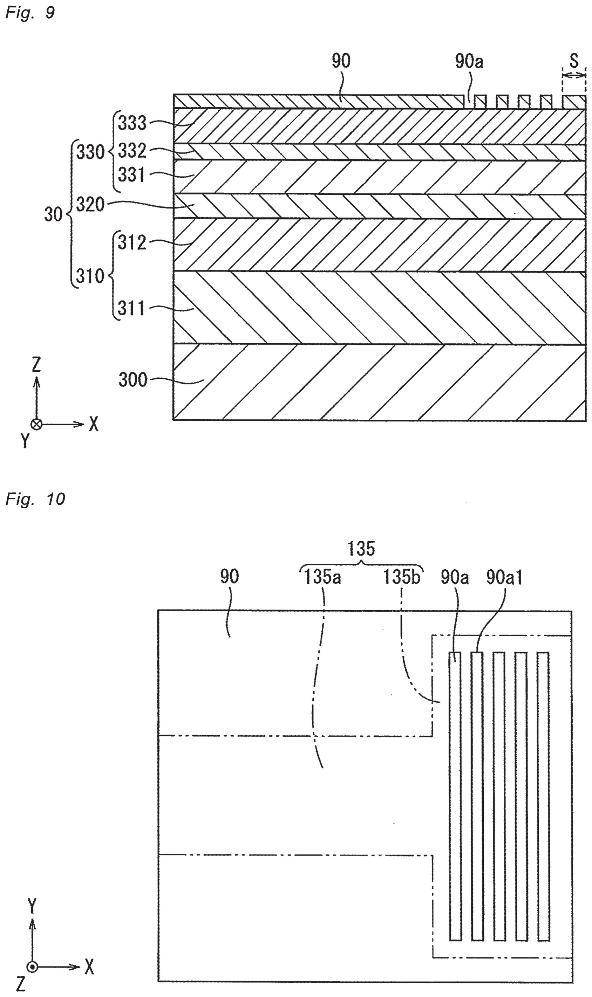

In the semiconductor laser element L1, the diffraction grating 20 may be provided at a location spaced apart from the light-emitting surface as illustrated in FIG. 9 and the like, which will be referred to in the description of a manufacturing step described later. Here, the expression "the diffraction grating 20 is spaced apart from the light-emitting surface" means that at least a distance between the diffraction grating 20 and the light-emitting surface is larger than the length of the period of the diffraction grating 20. The distance (S: see FIG. 9) between the diffraction grating 20 and the light-emitting surface is, for example, in a range of 10 $\mu$m to 100 $\mu$m, in a range of 20 $\mu$m to 80 $\mu$m, or in a range of 30 $\mu$m to 60 $\mu$m. When the light-emitting surface is spaced apart from the diffraction grating 20, the light-emitting surface is less likely to be affected by a stress applied to the diffraction grating 20, and thus reliability can be increased. For example, even when an anti-reflective film is provided on the light-emitting surface, the anti-reflective film can be made less likely to peel off from the light-emitting surface. Here, even in the case in which the diffraction grating 20 is provided at a location spaced apart from the light-emitting surface, it is preferable that the first protective film 50 that constitutes a part of the diffraction grating 20 and covers the diffraction grating 20 is provided to extend to the light-emitting surface. This allows the first protective film to be appropriately disposed in the recessed portions 22 located on the light-emitting surface side.

Resonator

The semiconductor laser element L1 oscillates laser light by resonating between the high-reflective film 62 of the first waveguide portion 1 and the diffraction grating 20 of the second waveguide portion 2, and a resonator is formed between the high-reflective film 62 of the first waveguide portion 1 and the diffraction grating 20 of the second waveguide portion 2. The resonator length (substantially equal to the length of the first waveguide portion 1) is, for example, in a range of 500 $\mu$m to 5000 $\mu$m, preferably in a range of 1000 $\mu$m to 5000 $\mu$m, and more preferably in a range of 1500 $\mu$m to 4000 $\mu$m. By setting the resonator length in the above-described range, the output of the laser light can be improved.

Electrode

The semiconductor laser element L1 of the embodiment includes the positive electrode 41 and the negative electrode 42. The positive electrode 41 is disposed so as to be in contact with at least the p-side semiconductor layer portion 330 in the first waveguide portion 1. The material of the positive electrode 41 is, for example, a light-transmissive oxide or a metal. The light-transmissive oxide is, for example, ITO or IZO. The metal is, for example, Ni, Au, Rh, Cr, W, Pt, Ti, Al, or a layer or an alloy thereof. The positive electrode 41 is preferably the light-transmissive oxide, which can reduce loss due to absorption of light by the electrode. The positive electrode 41 may further include, for example, an electrode made of a metal on the light-transmissive oxide. The positive electrode 41 is provided, for example, on the first ridge 135a of the ridge 135 except for on the second ridge 135b. This makes it possible to suppress heat generation due to energization of the diffraction grating and suppress the amount of wavelength shift due to an increase in an applied current. For example, when the substrate 300 is a conductive substrate, the negative electrode 42 can be disposed on the back surface of the substrate 300 as illustrated in FIG. 2 and the like. When the substrate 300 is not the conductive substrate, a region where the n-side semiconductor layer portion 310 is exposed is formed, and the negative electrode 42 can be formed in a part of this region. As a material of the negative electrode 42, the same material as the positive electrode 41 can be used.

The first protective film 50 is provided to be spaced apart from the positive electrode 41. The first protective film 50 and the positive electrode 41 do not overlap with each other in the top view. The shortest distance between the first protective film 50 and the positive electrode 41 may be 20 $\mu$m or more and 50 $\mu$m or less in the top view. With the positive electrode 41, which is a path of the current, located away from the first protective film 50, degradation of the first protective film 50 can be reduced.

Maximum Diffusion Angle $\Theta_{max}$

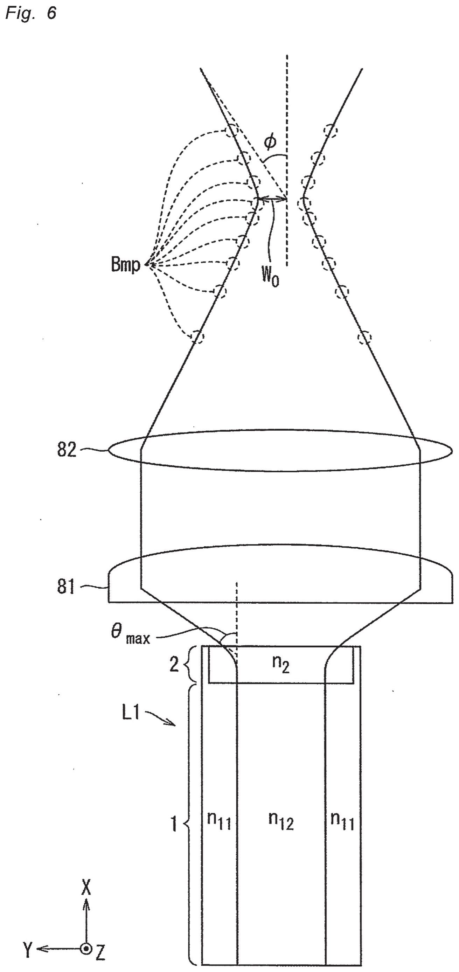

A method for measuring the maximum diffusion angle $\Theta_{max}$ will be described with reference to FIG. 6. FIG. 6 is a schematic diagram illustrating a method for measuring a factor $M^2$. In the semiconductor laser element L1 according to the embodiment, the maximum diffusion angle $\Theta_{max}$ can be determined by using the factor $M^2$, which is an index of laser beam quality and is defined by the following Equation (3). In Equation (3), $W_0$ is a beam waist radius, $\varphi$ is a beam divergence angle, and $\lambda$ is a wavelength of the laser light in vacuum. The factor $M^2$ is an index indicating divergence from an ideal Gaussian beam, and is 1 for the ideal Gaussian beam. That is, when the factor $M^2$ of the laser light output from the semiconductor laser element L1 is known, the extent to which the laser light diverges compared with the ideal Gaussian beam can be determined, and thus the maximum diffusion angle $\Theta_{max}$ is determined. Here, as illustrated in FIG. 6 and the like, the maximum diffusion angle $\Theta_{max}$ is an angle formed by a straight line obtained by removing a curved portion from the imaginary line and a straight line obtained by extending the boundary between the first core portion 13 and the first cladding portion 11.

$$M^2 = \pi\varphi W_0/\lambda \ ... \ (3)$$

The beam waist radius $W_0$ and the beam divergence angle $\varphi$ can be measured in the following manner using an optical system including a collimating lens 81 and a condenser lens 82 illustrated in FIG. 6. The laser light emitted from the first waveguide portion 1 is collimated by the collimating lens 81 and condensed by the condenser lens 82 to trace the locus of the condensed laser light. Specifically, the beam diameter of the condensed laser light is measured at various positions Bmp, the position where the beam diameter is the smallest is estimated, and the beam waist radius $W_0$ at that position is obtained. The divergence of the beam from the position where the beam diameter is the smallest is measured to determine the beam divergence angle $\varphi$. It should be noted that the definition of the parameters required for determining the factor $M^2$ is based on the International Organization for Standardization ISO 11146-1:2021 or ISO 11146-2:2021. The beam diameter is defined by D4$\sigma$ (second moment width). The value of the current fed to the semiconductor laser element L1 when measuring the factor $M^2$ is within a predetermined operating current range. The factor $M^2$ can be measured using a beam profiler.

The factor $M^2$ is calculated from Equation (3) using the determined beam waist radius $W_0$ and the determined beam divergence angle $\varphi$, and the maximum diffusion angle $\Theta_{max}$ is determined based on the factor $M^2$ as described above. The locus of the laser light emitted from the second waveguide portion 2 can be found from the factor $M^2$ and the locus of the laser light measured in the process of determining the factor $M^2$. Thus, the imaginary lines diverging at the maximum diffusion angle $\Theta_{max}$ from both ends of the emission end surface of the first core portion 13 are obtained. By comparing the positional relationship between the imaginary lines and the positional relationship between the imaginary lines and both ends of the first waveguide portion 1, the divergence of the laser light in the first waveguide portion 1 can be examined.

The factor $M^2$ of the laser light according to the first embodiment may be in a range of 2 to 100, in a range of 5 to 75, or in a range of 10 to 50. This provides the semiconductor laser element L1 having a large laser light output.

When the beam diameter of the laser light at the emission end surface of the laser light is smaller than the width of the second waveguide portion 2 and the width of the second waveguide portion 2 is substantially constant, it is apparent that both end portions of the second waveguide portion 2 are located outside of the imaginary lines. Accordingly, in such a case, the positional relationship between the width of the second waveguide portion 2 and the imaginary lines can be found without obtaining imaginary lines diverging at the maximum diffusion angle $\Theta_{max}$ by first measuring the beam diameter of the laser light at the emission end surface (that is, a first end surface 34) of the laser light.

As can be understood from the above description, the maximum diffusion angle $\Theta_{max}$ is an index indicating the maximum divergence of the laser light emitted from the first waveguide portion 1. A leakage of laser light that leaks out further outside the maximum divergence has a leakage amount that does not substantially affect the effective refractive index. In other words, the leakage amount of light is such that the effective refractive indices can be regarded as substantially the same for all transverse modes regardless of the mode order. Thus, the semiconductor laser element L1 of the embodiment in which the second waveguide portion 2 is provided with the diffraction grating 20 having both end portions formed outside the imaginary lines based on the maximum diffusion angle $\Theta_{max}$ can reduce the variation in oscillation wavelengths due to the difference in transverse mode and narrow the spectral line width.

Manufacturing Method

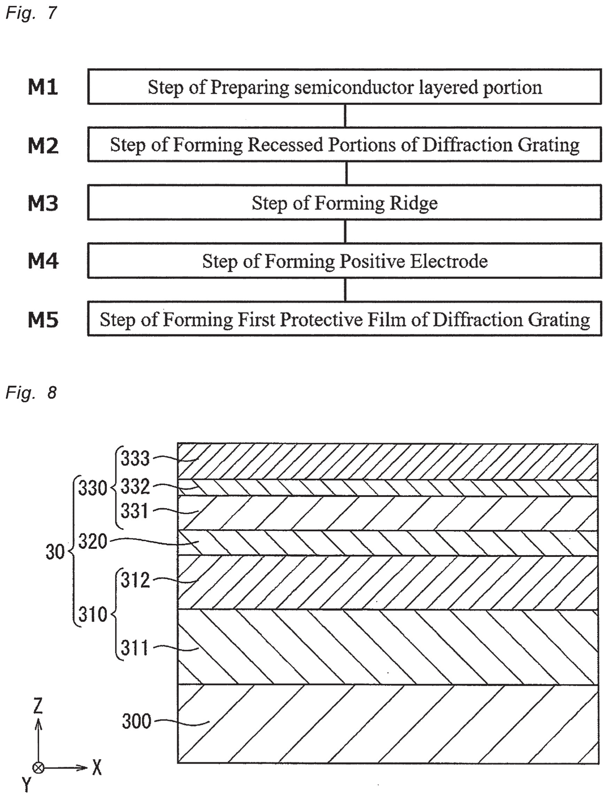

Next a method for manufacturing the semiconductor laser element L1 according to the first embodiment will be described. FIG. 7 is a flowchart illustrating the method for manufacturing the semiconductor laser element L1. The method for manufacturing the semiconductor laser element L1 includes a step M1 of preparing a semiconductor layered portion in which the n-side semiconductor layer, the active layer 320, and the p-side semiconductor layer are layered in order, a step M2 of forming the recessed portions of the diffraction grating 20 in the p-side semiconductor layer, a step M3 of forming the ridge 135, a step M4 of forming the positive electrode 41 on the p-side semiconductor layer, and a step M5 of forming the first protective film of the diffraction grating 20.

Each of the steps will be specifically described below.

The schematic cross-sectional views of FIGS. 8, 9, 11, 13, and 15 referred to in the following description are schematic cross-sectional views taken along the line II-II of FIG. 1. In a schematic top view of FIG. 10, a two-dot chain line indicates a portion where the ridge 135 is to be formed, and the ridge is not yet formed at that time.

Step of Preparing semiconductor layered portion

In the step of preparing the semiconductor layered portion, the semiconductor layered portion illustrated in FIG. 8 is prepared. The semiconductor layered portion includes the substrate 300, and the n-side semiconductor layer portion 310, the active layer 320, and the p-side semiconductor layer portion 330, which are formed on the substrate 300 in order. The n-side semiconductor layer portion 310 includes the n-side cladding layer 311 and the n-side light guide layer 312. The p-side semiconductor layer portion 330 includes the first p-side semiconductor layer 331, the electron blocking layer 332, and the second p-side semiconductor layer 333. The electron blocking layer 332 is disposed between the first p-side semiconductor layer 331 and the second p-side semiconductor layer 333. The semiconductor layered portion can be formed by, for example, a chemical vapor deposition method (CVD method) or a physical vapor deposition method (PVD method). The CVD method is, for example, a metal organic chemical vapor deposition method. The PVD method is, for example, a sputtering method or a molecular epitaxy method.

Step of Forming Recessed Portions of Diffraction Grating

Subsequently, the recessed portions 22 of the diffraction grating 20 are formed in the p-side semiconductor layer portion 330. In this step, for example, a mask layer is formed over the entire p-side semiconductor layer portion 330, and then a mask at positions where the recessed portions 22 are to be formed in the p-side semiconductor layer portion 330 is removed, thereby forming a mask 90 including openings 90a. The openings 90a of the mask 90 correspond to the period of the diffraction grating 20. Here, both end portions of the opening 90a of the mask 90 in a direction perpendicular to the period of the diffraction grating 20 are formed so as to be located inward of both lateral surfaces of the second ridge 135b of the ridge 135. A distance between the two end portions of the opening 90a of the mask 90 in the direction perpendicular to the period of the diffraction grating 20 and the two lateral surfaces of the second ridge 135b is, for example, in a range of 0.2 $\mu$m to 100 $\mu$m, and preferably in a range of 0.8 $\mu$m to 2.0 $\mu$m.

The lateral surface of the opening 90a located closest to the first ridge 135a in the mask 90 (lateral surface parallel to the direction perpendicular to the period of the diffraction grating 20) is formed at a location spaced apart from the end surface of the second ridge 135b on the first ridge 135a side to the light-emitting surface side. A distance between the lateral surface of the opening 90a located closest to the first ridge 135a in the mask 90 and the end surface of the second ridge 135b on the first ridge 135a side is, for example, in a range of 0.1 $\mu$m to 20 $\mu$m, and preferably in a range of 0.8 $\mu$m to 2.0 $\mu$m.

The openings 90a of the mask 90 are formed corresponding to the period of the diffraction grating 20, and are formed at intervals, for example, in a range of 60 nm to 400 nm, in a range of 70 nm to 300 nm, or in a range of 80 nm to 250 nm.

A patterning method for forming the openings 90a of the mask 90 is electron beam lithography, photolithography, nanoimprinting, or the like. When the patterning method is the electron beam lithography, finer openings of the mask can be formed. When the patterning method is the nanoimprinting, the openings can be collectively formed, and thus the openings of the mask 90 can be efficiently formed.

As illustrated in FIG. 9, the opening 90a located closest to the light-emitting surface of the mask 90 may be formed, for example, at a distance S from the end surface of the semiconductor layered portion, which is the light-emitting surface.

Here, the distance S between the opening 90a located closest to the light-emitting surface of the mask 90 and the light-emitting surface is, for example, in a range of 100 nm to 100 $\mu$m and preferably in a range of 30 $\mu$m to 50 $\mu$m.

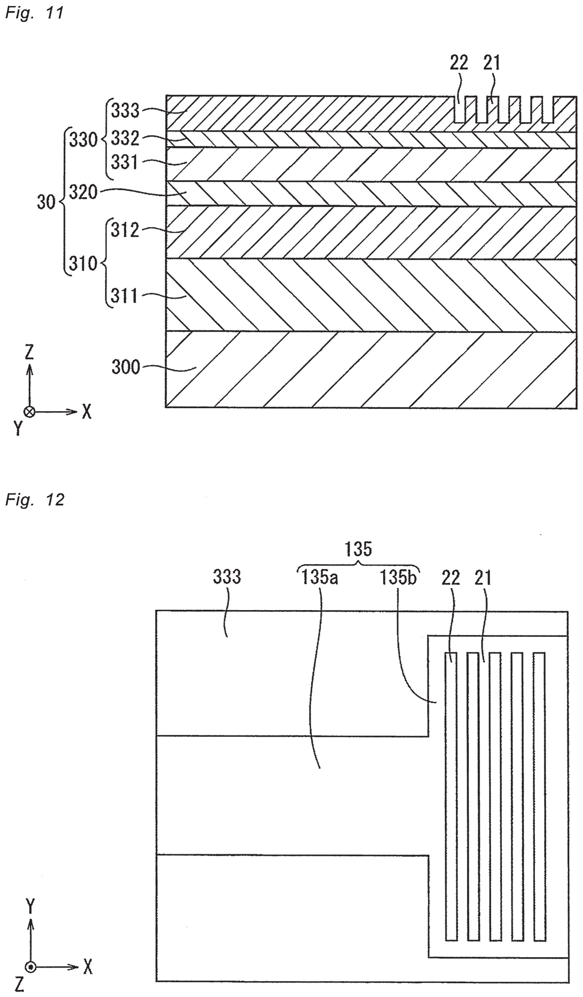

Subsequently, the p-side semiconductor layer portion 330 of portions exposed at the openings 90a of the mask 90 is removed by etching, thereby forming the plurality of recessed portions 22 in the p-side semiconductor layer portion 330. Although FIG. 11 illustrates an example in which the recessed portions 22 are formed in the second p-side semiconductor layer 333, the recessed portions 22 may be formed such that the bottom surfaces of the recessed portions 22 are located in the first p-side semiconductor layer 331 or the electron blocking layer 332. The plurality of recessed portions 22 are formed by dry etching such as reactive ion etching (RIE). A material of the mask 90 may be various resists, an oxide or a nitride such as $Al_2O_3$, $ZrO_2$, $SiO_2$, $TiO_2$, $Ta_2O_5$, AlN, or SiN, or a single-layer film or a multilayer film of a metal such as nickel or chromium. A film thickness of the mask 90 is, for example, in a range of 10 nm to 500 nm.

Step of Forming Ridge

Subsequently, a mask is formed on a region of the p-side semiconductor layer portion 330 where the ridge 135 is to be formed, and the second p-side semiconductor layer 333 on both sides of the ridge 135 is removed by dry etching or the like to form the ridge 135 (FIG. 12). In the ridge 135 the first ridge 135a corresponding to the first core portion 13 of the first waveguide portion 1 and the second ridge 135b corresponding to the second waveguide portion 2 are collectively formed. Although FIG. 12 illustrates an example in which the ridge 135 is formed in the second p-side semiconductor layer 333, the ridge 135 in which the lower end thereof is located in the first p-side semiconductor layer 331 may be formed by performing dry etching to the first p-side semiconductor layer 331.

Step of Forming Positive Electrode

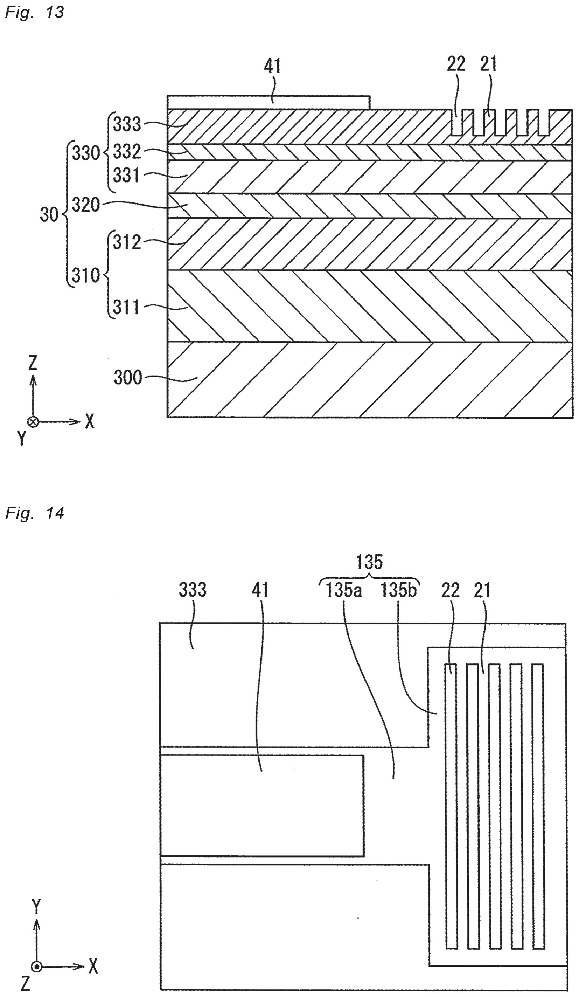

Subsequently, the positive electrode 41 is formed on the p-side semiconductor layer (FIGS. 13 and 14). The positive electrode 41 can be formed by, for example, forming a mask excluding a region where the positive electrode 41 is to be formed, depositing a material constituting the positive electrode 41 by a sputtering method or the like, and then removing the mask. The material of the positive electrode 41 can be constituted by a metal or a light-transmissive oxide having conductivity. The material of the positive electrode 41 is preferably the light-transmissive oxide having conductivity, and is, for example, ITO. By forming the positive electrode 41 with ITO, light absorption in the positive electrode 41 can be reduced. Thus, by using the ITO as the positive electrode 41, the ITO can also function as the p-side cladding layer. The negative electrode 42 is formed either before or after the step of forming the positive electrode 41.

Step of Forming First Protective Film of Diffraction Grating

Subsequently, the first protective film 50 having a refractive index different from that of the p-side semiconductor layer portion 330 is formed in the recessed portions 22 formed in the p-side semiconductor layer portion 330.

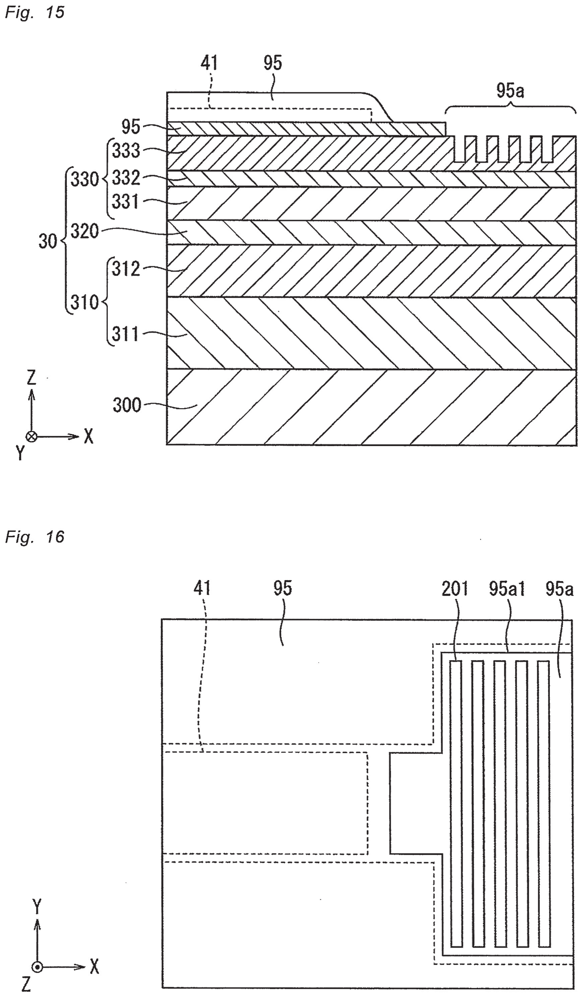

Here, first, as illustrated in FIGS. 15 and 16, a mask 95 including openings 95a is formed at a position where the first protective film 50 is to be formed. The mask 95 can be formed in the same manner as that of the mask 90, for example. The openings 95a of the mask 95 are formed so that an outer periphery 95a1 thereof is located between the outer periphery 135b1 of the second ridge 135b of the ridge 135 and the outer periphery 201 of the diffraction grating 20. Here, a distance between the outer periphery 95a1 of the openings 95a of the mask 95 and the outer periphery 201 of the diffraction grating 20 is, for example, in a range of 0.1 $\mu$m 99.8 $\mu$m, and preferably in a range of 0.4 $\mu$m to 1 $\mu$m. By setting the distance to this range, the first protective film 50 can be appropriately embedded in the recessed portions 22 without gaps.

A distance between the outer periphery 95a1 of the openings 95a of the mask 95 and the outer periphery 135b1 of the second ridge 135b is, for example, in a range of 0.2 $\mu$m 99.8 $\mu$m, and preferably in a range of 0.4 $\mu$m to 1.0 $\mu$m. By setting the distance to this range, the first protective film can be formed only in the second ridge region on the diffraction grating regardless of manufacturing errors.

Subsequently, a material of the first protective film is deposited in the openings 95a of the mask 95 by, for example, the atomic layer deposition method (ALD method) so as to fill the recessed portions 22, thereby forming the first protective film 50. The first protective film 50 is, for example, an oxide, a fluoride, or a nitride. The first protective film 50 can be formed by, for example, the sputtering method or the CVD method other than the atomic layer deposition method (ALD method), but is preferably formed by the ALD method. By forming the first protective film 50 by the ALD method, the recessed portions 22 can be densely filled with the first protective film 50, and the diffraction grating 20 having good wavelength selectivity can be formed.

The first protective film 50 may be provided to extend on the semiconductor layered portion 30 of the first ridge 135a, and thereby, an upper surface of the first ridge 135a can be protected.

In the case in which the first protective film 50 is provided to extend on the semiconductor layered portion 30 of the first ridge 135a, the first protective film 50 is preferably provided such that the outer periphery of the first protective film 50 is located inward of the outer periphery of the first ridge 135a in a top view of the first ridge 135a. By providing the first protective film 50 such that the outer periphery of the first protective film 50 is located inward of the outer periphery of the first ridge 135a, the first protective film 50 is not formed on the lateral surface of the first ridge 135a, and thus the possibility that the lateral surface of the first ridge 135a is oxidized can be reduced.

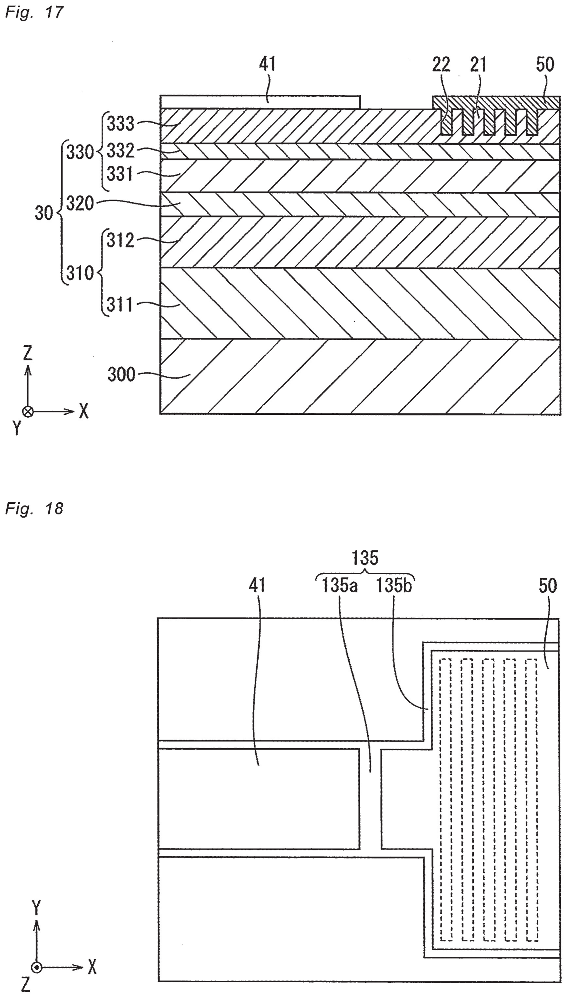

Subsequently, as illustrated in FIGS. 17 and 18, the mask 95 is removed.

By forming the diffraction grating 20 through the above steps, the first protective film constituting a part of the diffraction grating can be appropriately disposed at a necessary position.

By forming the diffraction grating 20 as described above, for example, an area of the second ridge 135b can be larger than an area of the first protective film 50, and the area of the first protective film 50 can be larger than an area of the diffraction grating 20 in a top view. This allows the first protective film to be more reliably provided such that the outer periphery of the first protective film excluding the light-emitting surface side and the boundary between the first ridge 135a and the second ridge 135b is located between the outer periphery of the second ridge 135b and the outer periphery of the diffraction grating 20 in a top view.

The method for manufacturing the semiconductor laser element L1 may include additional steps as necessary in addition to the steps described above. For example, the method for manufacturing the semiconductor laser element L1 may further include a step of forming a second protective film covering the entire upper surface of the semiconductor laser element L1 except for the upper surface of the positive electrode 41.

Although the above method for manufacturing the semiconductor laser element L1 has been described with reference to the drawings of one semiconductor laser element L1, the semiconductor laser element L1 may be manufactured by collectively forming a plurality of the semiconductor laser elements L on a wafer and then singulating the plurality of semiconductor laser elements L1. The singulation can be performed by, for example, cleavage or laser scribing.

## Claims

1. A semiconductor laser element comprising:

   a semiconductor layered portion comprising:

   a first semiconductor layer portion comprising a first conductivity-type semiconductor layer,
   a second semiconductor layer portion comprising a second conductivity-type semiconductor layer, and
   an active layer disposed between the first semiconductor layer portion and the second semiconductor layer portion;

   a ridge located in the semiconductor layered portion; and
   a diffraction grating; wherein:

   one end surface of the semiconductor laser element serves as a light-emitting surface;
   the ridge comprises:

   a first ridge extending in a first direction in a top view, and
   a second ridge comprising a first protective film located on the semiconductor layered portion, the second ridge located at a side of the light-emitting surface in a top view;

   the diffraction grating has a periodic structure alternately comprising a part of the second semiconductor layer portion and a part of the first protective film, and is located between the second semiconductor layer portion and the first protective film in the second ridge; and
   the first protective film is located such that, in a top view, an outer periphery of the first protective film excluding the side of the light-emitting surface and a boundary between the first ridge and the second ridge is located between an outer periphery of the second ridge and an outer periphery of the diffraction grating.

2. The semiconductor laser element according to claim 1, wherein the first protective film extends to the light-emitting surface in a top view.

3. The semiconductor laser element according to claim 1 or 2, wherein a width of the second ridge in a second direction perpendicular to the first direction is larger than a width of the first ridge.

4. The semiconductor laser element according to any one of claims 1 to 3, wherein:
   in a top view, an area of the second ridge is larger than an area of the first protective film, and the area of the first protective film is larger than an area of the diffraction grating.

5. The semiconductor laser element according to any one of claims 1 to 4, wherein:

   the first protective film extends on the semiconductor layered portion of the first ridge, and
   the first protective film is located such that, in a top view of the first ridge, an outer periphery of the first protective film is located inward of an outer periphery of the first ridge.

6. The semiconductor laser element according to any one of claims 1 to 5, further comprising a second protective film covering the first protective film.

7. The semiconductor laser element according to any one of claims 1 to 6, wherein a width of the second ridge in a second direction perpendicular to the first direction is larger than a beam diameter of laser light guided through a region overlapping the second ridge.

8. The semiconductor laser element according to any one of claims 1 to 7, wherein the semiconductor layered portion comprises a first cladding portion, a second cladding portion, and a first core portion located between the first cladding portion and the second cladding portion, the semiconductor layered portion being configured to propagate laser light in a plurality of transverse modes.

9. The semiconductor laser element according to any one of claims 1 to 8, wherein the first protective film is $SiO_2$.

10. The semiconductor laser element according to any one of claims 1 to 9, wherein an electrode is disposed on the first ridge of the ridge and is not disposed on the second ridge.

11. The semiconductor laser element according to any one of claims 1 to 10, wherein, in a top view, the diffraction grating is disposed at a position spaced apart from the light-emitting surface.

Fig. 1

Fig. 2

Fig. 3

Fig. 4

Fig. 5

Fig. 6

Fig. 7

| M1 | Step of Preparing semiconductor layered portion |
|----|--------------------------------------------------|
| M2 | Step of Forming Recessed Portions of Diffraction Grating |
| M3 | Step of Forming Ridge |
| M4 | Step of Forming Positive Electrode |
| M5 | Step of Forming First Protective Film of Diffraction Grating |

Fig. 8

Fig. 9

Fig. 10

Fig. 11

Fig. 12

Fig. 13

Fig. 14

Fig. 15

Fig. 16

Fig. 17

Fig. 18

Europäisches
Patentamt

European
Patent Office

Office européen
des brevets

## EUROPEAN SEARCH REPORT

**Application Number**

EP 25 21 0659

### DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 105 552 714 A (UNIV BEIJING TECHNOLOGY) 4 May 2016 (2016-05-04) * paragraph [0008] - paragraph [0046]; figures 1-7 * | 1-11 | INV. H01S5/00 H01S5/12 H01S5/22 H01S5/028 |
| A | JP S61 260696 A (FUJIKURA LTD; JAPAN RES DEV CORP) 18 November 1986 (1986-11-18) * paragraph [0001] - paragraph [0003] * | 1-11 | H01S5/042 H01S5/10 H01S5/20 H01S5/343 |
| A,D | US 2006/120421 A1 (MATSUDA MANABU [JP] ET AL) 8 June 2006 (2006-06-08) * paragraph [0173] - paragraph [0175]; figures 18,19 * | 1-11 | H01S5/125 |
| A | US 2012/020377 A1 (KONO NAOYA [JP]) 26 January 2012 (2012-01-26) * paragraph [0023] - paragraph [0036]; figures 1,2 * | 1-11 | |

**TECHNICAL FIELDS SEARCHED (IPC)**

H01S

The present search report has been drawn up for all claims

| Place of search | Date of completion of the search | Examiner |
|---|---|---|
| Munich | 25 March 2026 | Hervé, Denis |

EPO FORM 1503 03.82 (P04C01)

## ANNEX TO THE EUROPEAN SEARCH REPORT
## ON EUROPEAN PATENT APPLICATION NO.

EP 25 21 0659

This annex lists the patent family members relating to the patent documents cited in the above-mentioned European search report.
The members are as contained in the European Patent Office EDP file on
The European Patent Office is in no way liable for these particulars which are merely given for the purpose of information.

25-03-2026

| Patent document cited in search report | | Publication date | Patent family member(s) | | Publication date |
|---|---|---|---|---|---|
| CN 105552714 | A | 04-05-2016 | NONE | | |
| JP S61260696 | A | 18-11-1986 | NONE | | |
| US 2006120421 | A1 | 08-06-2006 | JP | 4422597 B2 | 24-02-2010 |
| | | | JP | 2006165027 A | 22-06-2006 |
| | | | US | 2006120421 A1 | 08-06-2006 |
| US 2012020377 | A1 | 26-01-2012 | JP | 2012028395 A | 09-02-2012 |
| | | | US | 2012020377 A1 | 26-01-2012 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2006165027 A